# EUROPÄISCHE PATENTSCHRIFT

(11) **EP 3 494 601 B1**
(45) Veröffentlichungstag und Bekanntmachung des Hinweises auf die Patenterteilung: **26.05.2021**
(21) Anmeldenummer: 17777156.5
(22) Anmeldetag: 01.08.2017
(51) Int. Cl.: H01L 31/0224, H01L 31/068

(54) **VERFAHREN ZUR VERBESSERUNG DES OHMSCHEN KONTAKTVERHALTENS ZWISCHEN EINEM KONTAKTGITTER UND EINER EMITTERSCHICHT EINER SILIZIUMSOLARZELLE**
METHOD FOR IMPROVING OHMIC CONTACT BEHAVIOUR BETWEEN A CONTACT GRID AND AN EMITTER LAYER OF A SILICON SOLAR CELL
PROCÉDÉ D'AMÉLIORATION DU COMPORTEMENT DE CONTACT OHMIQUE ENTRE UNE GRILLE DE CONTACTS ET UNE COUCHE ÉMETTRICE D'UNE CELLULE SOLAIRE AU SILICIUM

(30) Priorität: 02.08.2016 DE 102016009560
(43) Veröffentlichungstag der Anmeldung: 12.06.2019
(73) Patentinhaber: Heraeus Deutschland GmbH & Co. KG, 63450 Hanau (DE)
(72) Erfinder: HONGMING, Zhao, 06114 Halle/Saale (DE)
(74) Vertreter: Findeisen, Andreas
(86) Internationale Anmeldenummer: PCT/DE2017/000245
(87) Internationale Veröffentlichungsnummer: WO 2018/024274

(56) Entgegenhaltungen:
- EP-A2- 0 087 776
- US-A1- 2011 306 163
- US-A1- 2012 028 396
- US-A1- 2013 146 576
- US-A1- 2014 069 494
- US-B2- 9 202 964

## Beschreibung

Die Erfindung betrifft ein Verfahren zur Verbesserung des ohmschen Kontaktverhaltens zwischen einem Kontaktgitter und einer Emitterschicht einer Siliziumsolarzelle.

Im Zuge des Herstellungsprozesses von kristallinen Siliziumsolarzellen wird eine Metallpaste auf die mit dielektrischem Siliziumnitrid beschichtete Frontseite in Form eines Kontaktgitters im Siebdruckverfahren aufgetragen. Für die Kontaktierung der unterhalb der Siliziumnitridschicht liegenden Emitterschicht der Siliziumsolarzelle wird nach dem Auftragen der Metallpaste ein Temperschritt bei 800 - 900 °C durchgeführt. Dabei diffundiert das Silber der Metallpaste unterstützt durch eine in der Metallpaste enthaltene Glasfritte durch die Siliziumnitridschicht in die Emitterschicht ein. Die Prozessführung während des Temperschrittes hat dabei einen entscheidenden Einfluss auf die Kontaktausbildung. Bei einer korrekten Prozessführung ist der Übergang zwischen dem Kontaktgitter und der Emitterschicht von einem niedrigen Kontaktwiderstand gekennzeichnet. Bei einer fehlerhaften Prozessführung wird meist nur ein hoher Kontaktwiderstand erreicht. Werden im Temperschritt beispielsweise zu niedrige Temperaturen angewendet, kann die Metallpaste nicht im ausreichenden Maße durch die Siliziumnitridschicht diffundieren, womit sich nur eine geringe Kontaktfläche und damit ein hoher Kontaktwiderstand zwischen Kontaktgitter und Emitterschicht ausbildet. Hohe Kontaktwiderstände führen wiederum zu stark reduzierten Wirkungsgraden bei den Solarzellen, sodass diese dann nicht in Solarmodulen verbaut werden können und damit Ausschuss sind.

Aus dem Stand der Technik sind vereinzelt Verfahren bekannt, die eine Wirkungsgradstabilisierung oder Leistungsverbesserung von Solarzellen ermöglichen. So beschreibt DE 10 2011 056 843 A1 ein Verfahren zur "Stabilisierung eines Wirkungsgrades von Siliziumsolarzellen". Zum Aufbau eines Solarmodules werden die Solarzellen zunächst zu einem Solarzellenverbund elektrisch verschaltet und anschließend in einem Laminierprozess zwischen zwei Glasscheiben oder zwischen einer Glasscheibe und einer Rückseitenfolie einlaminiert. In der genannten Schrift wird vorgeschlagen, während des Laminierprozesses einen kontinuierlichen Stromfluss in den Solarzellenverbund einzuprägen und damit Überschussminoritätsladungsträger zu erzeugen. Die Stromstärke des eingeprägten Stroms liegt dabei unterhalb der einfachen Kurzschlussstromstärke der Siliziumsolarzellen. Mit einem derartigen Verfahren werden im Wesentlichen Bor-Sauerstoff-Komplexe im Siliziummaterial rückgebildet. Ein Effekt auf den Kontaktwiderstand zwischen Kontaktgitter und Emitterschicht wird nicht beschrieben.

In US 4 166 918 A wird ein Verfahren zur Leistungsverbesserung einer Solarzelle vorgeschlagen, wobei die Solarzelle mit einer entgegen ihrer Vorwärtsrichtung angelegten Spannung beaufschlagt wird. Dabei wird ein Stromfluss entlang von Kurzschlüssen innerhalb der Solarzelle angeregt, wodurch diese Bereiche der Solarzelle erhitzt werden und in der Folge die Kurzschlüsse "ausgebrannt" und damit eliminiert werden. Ein Effekt auf den Übergang zwischen Kontaktgitter und Emitterschicht wird auch bei diesem Verfahren nicht beschrieben.

Die DD 250 247 A3 beschreibt ein Verfahren zur Verbesserung des ohmschen Kontaktverhaltens chipgeklebter Halbleiterkörper. Diese Halbleiterkörper sind über einen elektrisch leitfähigen Klebestoff mit einem Trägermaterial fixiert und mit einem Drahtbond kontaktiert. Durch Anlegen eines Spannungspulses zwischen Trägermaterial und Bonddraht wird der Halbleiterkörper mit einem gerichteten elektrischen Impuls belastet. Dabei wird das ohmsche Kontaktverhalten zwischen Trägermaterial und Halbleiterkörper verbessert und damit der Ausschuss verringert. Der Wirkmechanismus der Kontaktverbesserung wird in der Schrift nicht näher beschrieben. Die bei der Kontaktierung verwendeten elektrisch leitfähigen Klebstoffe bestehen im Wesentlichen aus elektrisch leitfähigen Partikeln, meist Silberkugel oder Silberflakes, die von einer Polymermatrix umgeben sind. Das Kontaktverhalten wird dann entscheidend davon beeinflusst, wie viele Partikel einen direkten Kontakt zur kontaktierten Oberfläche haben. Ein direkter Kontakt eines Partikels zur Oberfläche kann dabei von einer Zwischenschicht aus Polymer verhindert werden. Es ist zu vermuten, dass mit dem beschriebenen Verfahren eine derartige Zwischenschicht durch Anlegen eines Strompulses "weggebrannt" wird und die Partikel anschließend einen direkten Kontakt zur Oberfläche aufweisen. Eine derartige polymere Zwischenschicht liegt am Übergang zwischen Kontaktgitter und Emitterschicht einer Siliziumsolarzelle allerdings nicht vor. Die für das Verfahren genutzten Stromstärken liegen im Bereich der Grenzbeanspruchung der chipgeklebten Halbleiterkörper, wobei Stromstärken von etwa 1 A angegeben werden. Im Betrieb von Siliziumsolarzellen der Größe 15 cm x 15 cm werden üblicherweise Stromstärken in der Größenordnung von 5 A bis 10 A und damit deutlich höhere Stromstärken erreicht. Ein Effekt auf den Übergang zwischen Kontaktgitter und Emitterschicht einer Siliziumsolarzelle ist bei diesen Stromstärken nicht bekannt

In US2012028396 A1 wird ein Verfahren zum Ausbilden von selektiven Emittern auf der Vorder- und der Rückseite einer Siliziumsolarzelle mithilfe Strompulsen beschrieben.

Aufgabe der Erfindung ist es, ein Verfahren zur Verbesserung des Kontaktverhaltens zwischen dem Kontaktgitter und der Emitterschicht von Siliziumsolarzellen vorzuschlagen, welches nach der Kontaktierung dieser Solarzellen angewendet wird und damit der Ausschuss an Solarzellen mit mangelhafter Kontaktierung reduziert wird.

Diese Aufgabe wird dadurch gelöst, dass ein Verfahren angewandt wird, welches durch die folgenden Schritte gekennzeichnet ist. Zunächst wird eine Siliziumsolarzelle mit der Emitterschicht, dem Kontaktgitter und einem Rückkontakt bereitgestellt. Anschließend werden das Kontaktgitter von einer mit einem Pol einer Stromquelle verbundenen ersten Kontaktiereinrichtung elektrisch kontaktiert und der Rückkontakt von einer mit dem anderen Pol der Stromquelle verbundenen zweiten Kontaktiereinrichtung elektrisch verbunden. Über die Stromquelle wird dann mindestens ein Strompuls mit einer Pulslänge von 1 ms bis 100 ms und einer Stromstärke, die dem 10- bis 30-fachen der Kurzschlussstromstärke der Siliziumsolarzelle entspricht, entlang der Vorwärtsrichtung der Siliziumsolarzelle induziert.

Vorteilhafterweise ist die erste Kontaktiereinrichtung als eine Kontaktstift-Matrix oder eine Kontaktplatte ausgebildet.

Alternativ wird ein Verfahren, welches durch die folgenden Schritte charakterisiert ist, vorgeschlagen. Zunächst wird eine Siliziumsolarzelle mit der Emitterschicht, dem Kontaktgitter und einem Rückkontakt bereitgestellt. Anschließend werden ein Teilbereich des Kontaktgitters von einer mit einem Pol einer Stromquelle verbundenen Kontaktbürste oder Kontaktwalze elektrisch kontaktiert und der Rückkontakt von einer mit dem anderen Pol der Stromquelle verbundenen Kontaktiereinrichtung elektrisch verbunden. Die Kontaktbürste oder die Kontaktwalze werden dann über das Kontaktgitter geführt, wobei dabei mit der Stromquelle ein Strom entlang der Vorwärtsrichtung der Siliziumsolarzelle induziert wird, der eine Stromstärke aufweist, die der um das Verhältnis aus der Fläche des Teilbereichs zur Fläche der Siliziumsolarzelle reduzierten 10- bis 30-fachen Kurzschlussstromstärke der Siliziumsolarzelle entspricht. Jeder Teilbereich wird für eine Zeit zwischen 1 ms und 100 ms von diesem Strom durchflossen. Dies kann dadurch erreicht werden, dass entweder von der Stromquelle Strompulse mit den entsprechenden Pulslängen erzeugt werden oder der Vorschub der Kontaktwalze bzw. Kontaktbürste so gewählt wird, dass bei einem von der Stromquelle bereitgestellten kontinuierlichen Stromfluss jeder Bereich für etwa 1 ms bis 100 ms durchflossen wird.

Ein weiteres alternatives Verfahren ist durch die folgenden Verfahrensschritte gekennzeichnet. Zunächst wird eine Siliziumsolarzelle mit der Emitterschicht, dem Kontaktgitter und einem Rückkontakt bereitgestellt. Anschließend werden das Kontaktgitter mit einem Pol einer Spannungsquelle und der Rückkontakt von einer mit dem anderen Pol der Spannungsquelle verbundenen Kontaktiereinrichtung elektrisch verbunden. Dann wird mit der Spannungsquelle eine entgegen der Vorwärtsrichtung der Siliziumsolarzelle gerichtete Spannung angelegt. Beim Anliegen dieser Spannung wird dann eine Punktlichtquelle über die sonnenzugewandte Seite der Siliziumsolarzelle geführt. Die angelegte Spannung und die Punktlichtquelle werden dabei so gewählt, dass in dem Teilbereich ein Stromfluss induziert wird, wobei dieser Stromfluss für 1 ms bis 100 ms auf den Teilbereich einwirkt und der Stromfluss eine Stromstärke aufweist, die der um das Verhältnis aus der Fläche des Teilbereichs zur Fläche der Siliziumsolarzelle reduzierten 10-bis 30-fachen der unter Standard-Testbedingungen gemessenen Kurzschlussstromstärke der Siliziumsolarzelle entspricht. Durch die Punktlichtquelle wird die Kennlinie der Solarzelle lokal verschoben, so dass im beleuchteten Bereich der Siliziumsolarzelle ein Strom fließen kann. Die Einwirkzeiten von 1 ms bis 100 ms können erreicht werden, indem die Punktlichtquelle eine dementsprechend gepulste Strahlung erzeugt oder indem die Punktlichtquelle eine kontinuierliche Strahlung aussendet und mit entsprechender Vorschubgeschwindigkeit über die sonnenzugewandte Seite der Siliziumsolarzelle geführt wird.

In einer vorteilhaften Ausgestaltung ist die Punktlichtquelle ein Laser.

Mit der Anwendung eines der erfindungsgemäßen Verfahren wird bei Siliziumsolarzellen mit einem hohen Kontaktwiderstand zwischen Kontaktgitter und Emitterschicht eine deutliche Verbesserung des ohmschen Kontaktverhaltens erreicht. Durch die Verringerung eines anfänglich hohen Kontaktwiderstandes zwischen Kontaktgitter und Emitterschicht wird der Wirkungsgrad dieser Siliziumsolarzellen deutlich erhöht, sodass diese nicht als Ausschuss verworfen werden müssen. Somit eignet sich das Verfahren zur Erhöhung der Ausbeute nach dem eigentlichen Herstellungsprozess. Das Verfahren kann vom Hersteller der Siliziumsolarzellen selbst oder auch von einem Dritten angewandt werden, der die fehlerbehafteten Siliziumsolarzellen mit dem erfindungsgemäßen Verfahren verbessert.

Weiterhin ist es aber auch denkbar, das erfindungsgemäße Verfahren als Bestandteil des Herstellungsprozesses einzuführen. Dabei ergibt sich der Vorteil, dass beispielsweise die Prozessführung des Temperschrittes weniger strikt eingehalten werden muss und ein hoher Kontaktwiderstand durch ein mangelhaftes Eindiffundieren der Metallpaste zunächst in Kauf genommen wird und mit dem erfindungsgemäßen Vorgehen als nachgelagerten Verfahrensschritt korrigiert wird. Damit kann der Aufwand zur Prozesskontrolle und Prozessregelung minimiert werden. Ebenso ist es möglich generell niedrigere Temperaturen während des Temperschritts einzuführen und damit zunächst nur eine geringe Kontaktfläche zwischen Kontaktgitter und Emitterschicht zu erreichen. Durch anschließendes Anwenden des erfindungsgemäßen Verfahrens kann dann die Kontaktfläche weiter vergrößert werden. Auch ist es denkbar, die Dotierung des Emitters für eine verbesserte Lichteinkopplung zu Reduzieren und dennoch, durch Anwendung des erfindungsgemäßen Verfahrens einen geringen Kontaktwiederstand zu erzielen.

Durch die Kontaktstift-Matrix oder die Kontaktplatte bzw. die geführte Kontaktbürste oder Kontaktwalze wird ein homogenes Einprägen der Strompulse über die Fläche der Siliziumsolarzelle gewährleistet. Insbesondere durch die Anwendung der lokalen Lichtquelle lässt sich nicht nur ein homogenes Einprägen des Stromes erreichen sondern auch der Stromeintrag gezielt nach vorgegebenen Mustern steuern.

Nachfolgend werden Ausführungsbeispiele der Erfindung anhand der Zeichnungen erläutert. Es zeigen:
- Fig. 1: Schematische Darstellung einer Siliziumsolarzelle
- Fig. 2: Siliziumsolarzelle mit einer auf dem Kontaktgitter aufgesetzten Kontaktstift-Matrix
- Fig. 3: Siliziumsolarzelle mit einer auf dem Kontaktgitter aufgesetzten Kontaktbürste
- Fig. 4: Siliziumsolarzelle mit einer auf dem Kontaktgitter aufgesetzten Kontaktwalze
- Fig. 5: Siliziumsolarzelle mit dem Kontaktgitter und einer durch eine Punktlichtquelle beleuchteten sonnenzugewandten Seite.

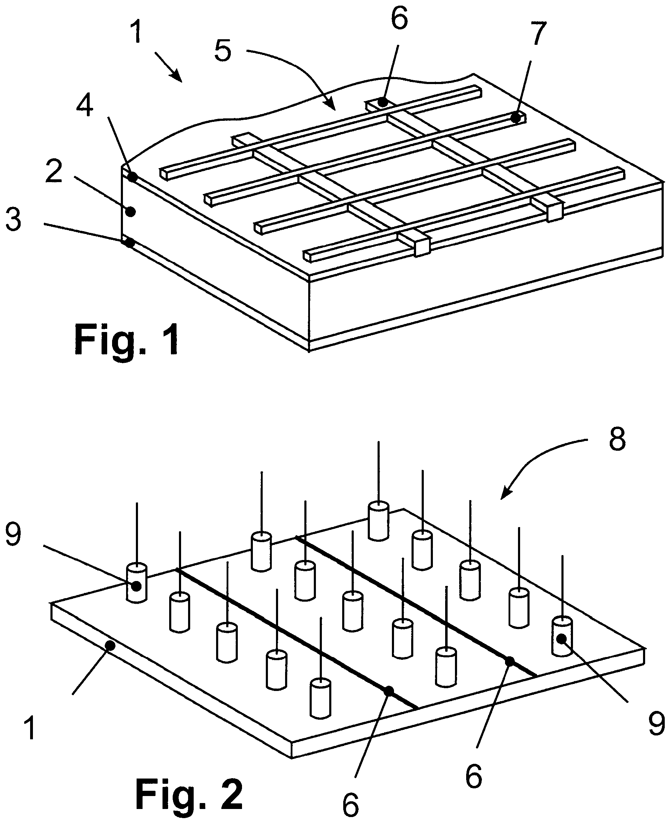

**Fig. 1** zeigt schematisch einen vereinfachten Aufbau einer Siliziumsolarzelle 1. Diese weist eine Absorberschicht 2 auf, die aus einer p-dotierten und einer n-dotierten Siliziumschicht aufgebaut ist, wobei sich am Übergang zwischen beiden Schichten ein pn-Übergang ausbildet, der typischerweise einen Diodencharakter aufweist. Auf einer sonnenabgewandten Seite der Siliziumsolarzelle 1 wird auf der p-dotierten Siliziumschicht ein meist flächiger Rückkontakt 3 aufgebracht. Auf einer hierzu gegenüberliegenden, sonnenzugewandten Seite der Siliziumsolarzelle 1 ist üblicherweise auf der n-dotierten Siliziumschicht (Emitterschicht) eine dielektrische Siliziumnitridschicht 4 angeordnet. Auf dieser wird wie oben beschrieben ein Kontaktgitter 5 aus einer Metallpaste aufgebaut. Das Kontaktgitter 5 üblicher Siliziumsolarzellen 1 besteht aus Busbars 6 und hierzu quer verlaufenden Kontaktfingern 7. Aufgrund des Diodencharakters des pn-Übergangs weist die Siliziumsolarzelle 1 eine Vorwärtsrichtung und eine Durchbruchsspannung auf. Weiterhin ist die Siliziumsolarzelle 1 von einer Kurzschlussstromstärke unter Standard-Testbedingungen (Beleuchtungsstärke: 1000 W/m², Temperatur der Siliziumsolarzelle: 25 °C) charakterisiert. Sowohl diese Kenngrößen als auch die Standard-Testbedingungen sind dem Fachmann bekannt und werden an dieser Stelle nicht näher erläutert. Eine derartige Siliziumsolarzelle 1 ist Ausgangspunkt des erfindungsgemäßen Verfahrens.

**Fig. 2** zeigt schematisch die Siliziumsolarzelle 1 mit dem Kontaktgitter 5, wobei in der Abbildung nur die Busbars 6 und keine Kontaktfinger 7 dargestellt sind. Die sonnenabgewandte Seite der Siliziumsolarzelle 1 ist in der Abbildung nicht sichtbar. Nachdem die Siliziumsolarzelle 1 bereitgestellt wurde, wird auf dem Kontaktgitter 5 eine Kontaktstift-Matrix 8 ausgebildete erste Kontaktiereinrichtung aufgesetzt, wobei alle Kontaktstifte 9 dieser Matrix elektrisch miteinander verbunden sind. Die Kontaktstifte 9 stützen sich auf den Kontaktfingern 7 des Kontaktgitters 5 ab. Grundsätzlich können aber auch nur die Busbars 6 oder sowohl die Busbars 6 als auch die Kontaktfinger 7 kontaktiert werden. Die Kontaktstifte 9 können dabei Federstifte sein, damit eine sichere Kontaktierung des Kontaktgitters 5 gewährleistet wird. Idealerweise sind die Kontaktstifte 9 homogen über das Kontaktgitter 5 verteilt. Alternativ kann anstatt der Kontaktstift-Matrix 8 auch eine Kontaktplatte auf das Kontaktgitter 5 aufgesetzt werden, sodass diese vollflächig von der Kontaktplatte kontaktiert wird.

Der nächste Schritt des Verfahrens sieht das Aufsetzen einer zweiten Kontaktiereinrichtung auf den Rückkontakt 3 vor. Diese ist in der Abbildung nicht sichtbar. Die zweite Kontaktiereinrichtung kann beispielsweise eine Matrix aus Federstiften oder eine metallische Platte zur vollflächigen Kontaktierung des Rückkontaktes 3 sein. Verfahrenstechnisch kann das Aufsetzen der zweiten Kontaktiereinrichtung auch vor dem Aufsetzen der ersten Kontaktiereinrichtung erfolgen.

Die Kontaktstift-Matrix 8 ist mit einem Pol einer Stromquelle verbunden. An dem anderen Pol dieser Stromquelle ist die zweite Kontaktiereinrichtung angeschlossen. Die Stromquelle ist in der Abbildung nicht dargestellt.

Nach dem Aufsetzen der Kontaktstift-Matrix 8 und der zweiten Kontaktiereinrichtung wird von der Stromquelle ein Strompuls induziert, wobei der Stromfluss entlang der Vorwärtsrichtung der Siliziumsolarzelle 1 verläuft. Der Strompuls hat eine Pulslänge von 1 ms bis 100 ms und eine Stromstärke im Bereich der 10- bis 30-fachen Kurzschlussstromstärke der Siliziumsolarzelle 1. Neben dem Einprägen eines Strompulses ist auch das Einprägen einer Pulsabfolge grundsätzlich möglich. Dabei können die einzelnen Strompulse identisch dimensioniert sein. Ebenso können die Pulse unterschiedlich dimensioniert sein, sodass beispielsweise zunächst ein Strompuls mit einer Pulslänge von 50 ms und einer Stromstärke der 10-fachen Kurzschlussstromstärke und anschließend ein Strompuls mit einer Pulslänge von 5 ms und einer Stromstärke der 30-fachen Kurzschlussstromdichte eingeprägt wird. Eine Siliziumsolarzelle 1 mit einer Dimension von 15 cm x 15 cm hat üblicherweise eine Kurzschlussstromstärke von 5 A bis 10 A. In diesem Fall werden beim erfindungsgemäßen Verfahren für einen Strompuls Stromstärken von 50 A bis 300 A erreicht. Durch die Kontaktierung des Kontaktgitters 5 mit einer Kontaktstift-Matrix 8 oder einer Kontaktplatte wird sichergestellt, dass Strompulse mit derart hohen Stromstärken homogen auf die gesamte Siliziumsolarzelle 1 verteilt werden und die mit den lateralen Abmessungen verbundenen Serienwiderstände entlang des Kontaktgitters 5 vernachlässigt werden können.

Bei einem niedrigen Kontaktwiderstand zwischen dem Kontaktgitter 5 und der Emitterschicht führt ein Strompuls mit Stromstärken und Pulslängen der genannten Größenordnungen nur zu einer geringen Erwärmung am Übergang zwischen Kontaktgitter 5 und Emitterschicht. Die Erwärmung ist im Wesentlichen auf den Leistungsabfall über den Kontaktwiderstand zurückzuführen. Eine geringe Erwärmung hat keinen Einfluss auf das ohmsche Kontaktverhalten des Übergangs. Liegt allerdings ein hoher Kontaktwiderstand zwischen dem Kontaktgitter 5 und der Emitterschicht vor, so resultiert der Strompuls in einem deutlich höheren Leistungsabfall und damit in einer deutlich höheren Erwärmung des Übergangs. Es wird davon ausgegangen, dass in den Bereichen mit geringer Kontaktfläche zwischen Kontaktgitter 5 und Emitterschicht lokal Temperaturen auftreten, die in der Größenordnung der beim Temperprozess verwendeten Temperaturen liegen. Damit kann ein lokales Aufschmelzen des Kontaktgitters 5 bzw. der Metallpaste ausgelöst werden, was dazu führt, dass die Metallpaste weiter durch die Siliziumnitridschicht 4 diffundiert und im Ergebnis die Kontaktfläche zwischen Kontaktgitter 5 und Emitterschicht vergrößert und damit der Kontaktwiderstand verringert wird. Durch die zeitliche Begrenzung der Strompulse wird eine zeitliche Begrenzung der Erwärmung sichergestellt, sodass die Metallpaste nicht weiter durch die Emitterschicht diffundiert und hier das Gefüge der Absorberschicht 2 zerstört oder aber gar bis zum Rückkontakt 3 der Siliziumsolarzelle 1 diffundiert und damit einen Kurzschluss dieser provoziert.

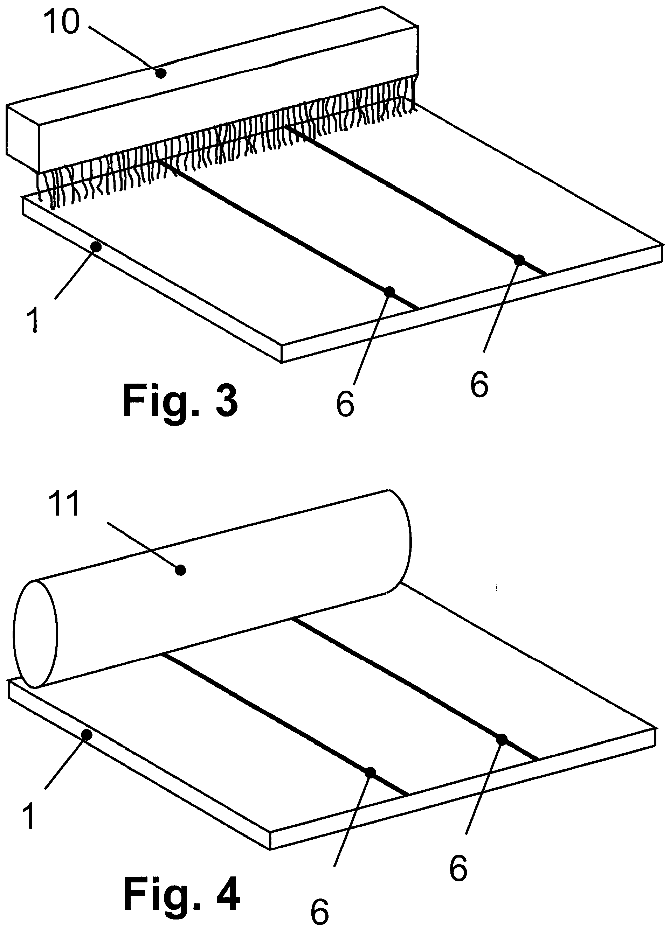

Das erfindungsgemäße Verfahren kann dahingehend abgewandelt werden, dass das Kontaktgitter 5 nicht mit einer Kontaktstift-Matrix 8 oder eine Kontaktplatte kontaktiert wird, sondern auf einem Teilbereich des Kontaktgitters beispielsweise eine Kontaktbürste 10 (Fig. 3) oder eine Kontaktwalze 11 (Fig. 4) aufgesetzt und diese entlang des Kontaktgitters 5 geführt werden.

**Fig. 3** zeigt die Siliziumsolarzelle 1 wobei ein Teilbereich des Kontaktgitters 5 von einer mit einem Pol einer Stromquelle verbundenen Kontaktbürste 10 elektrisch kontaktiert ist. Von dem Kontaktgitter 5 sind nur die Busbars 6 und keine Kontaktfinger 7 dargestellt. Der Rückkontakt 3 ist über eine mit dem anderen Pol der Stromquelle verbundene Kontaktiereinrichtung elektrisch verbunden, wobei die Kontaktiereinrichtung und der Rückkontakt 3 nicht dargestellt sind. Nach dem Aufsetzen der Kontaktbürste 10 auf dem Kontaktgitter 5 wird diese entlang des Kontaktgitters 5 geführt. Dabei werden von der Stromquelle Strompulse entlang der Vorwärtsrichtung der Siliziumsolarzelle 1 induziert. Die Strompulse weisen dabei eine Pulslänge von 1 ms bis 100 ms auf und haben eine Stromstärke, die der um das Verhältnis aus der Fläche des Teilbereichs zur Fläche der Siliziumsolarzelle 1 reduzierten 10- bis 30-fachen Kurzschlussstromstärke der Siliziumsolarzelle 1 entspricht. Beispielsweise kann der von der Kontaktbürste 10 kontaktierte Teilbereich ein Viertel des Kontaktgitters 5 umfassen. Die Stromstärke des eingeprägten Strompulses liegt für diesen Fall damit im Bereich von der 2,5- bis 7,5-fachen Kurzschlussstromstärke. Alternativ zum gepulsten Strom kann auch ein kontinuierlicher Strom verwendet werden, wobei der zeitliche Eintrag durch den Vorschub der Kontaktbürste geregelt wird.

Die Kontaktbürste 10 wird kontinuierlich entlang des Kontaktgitters 5 geführt. Es ist allerdings auch möglich, zunächst die Kontaktbürste 10 auf einem Teilbereich des Kontaktgitters 5 abzusetzen und mindestens einen Strompuls einzuprägen. Anschließend wird die Kontaktbürste 10 auf einen weiteren Teilbereich des Kontaktgitters 5 geführt und es wird wiederum mindestens ein Strompuls eingeprägt. Entsprechend der Dimensionen des Kontaktgitters 5 werden diese Schritte wiederholt.

Die Borsten der Kontaktbürste 10 sind so ausgebildet, dass beim Führen der Kontaktbürste 10 keine Beschädigungen (z.B. Kratzer) der Oberfläche der Siliziumsolarzelle 1 verursacht werden.

**Fig. 4** zeigt die Siliziumsolarzelle 1 aus **Fig. 3** wobei der Teilbereich des Kontaktgitters 5 anstelle der Kontaktbürste 10 von der Kontaktwalze 11 elektrisch kontaktiert ist. Von dem Kontaktgitter sind nur die Busbars 6 dargestellt. Nach dem Aufsetzen der Kontaktwalze 11 auf dem Kontaktgitter 5 wird diese entlang des Kontaktgitters 5 geführt. Dabei werden von der Stromquelle Strompulse entlang der Vorwärtsrichtung der Siliziumsolarzelle 1 induziert. Die Strompulse weisen dabei eine Pulslänge von 1 ms bis 100 ms auf und haben eine Stromstärke, die der um das Verhältnis aus der Fläche des Teilbereichs zur Fläche der Siliziumsolarzelle 1 reduzierten 10- bis 30-fachen Kurzschlussstromstärke der Siliziumsolarzelle 1 entspricht. Ist die Kontaktwalze 11 beispielsweise so ausgebildet, dass der Teilbereich etwa 10% des Kontaktgitters 5 umfasst, so ist für den Strompuls eine Stromstärke im Bereich von der einfachen bis dreifachen Kurzschlussstromstärke anzuwenden. Alternativ zum gepulsten Strom kann auch ein kontinuierlicher Strom verwendet werden, wobei der zeitliche Eintrag durch den Vorschub der Kontaktwalze geregelt wird.

Auch die Kontaktwalze 11 ist so ausgebildet, dass beim Führen der Kontaktwalze 11 keine Beschädigungen (z.B. Kratzer) der Oberfläche der Siliziumsolarzelle 1 hervorgerufen werden.

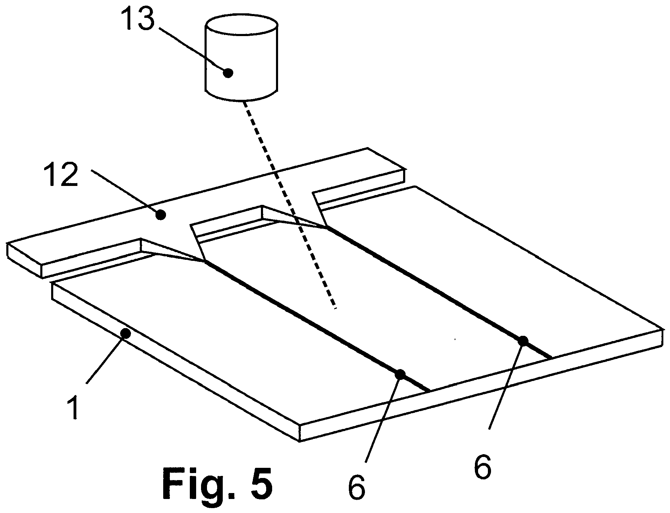

In **Fig. 5** ist eine Anordnung zu einem alternativen erfindungsgemäßen Verfahren dargestellt. Das alternative Verfahren umfasst dabei die folgenden Verfahrensschritte. Zunächst wird eine Siliziumsolarzelle 1 mit der Emitterschicht, dem Kontaktgitter 5 und dem Rückkontakt 3 bereitgestellt. Anschließend werden das Kontaktgitter 5 mit einem Pol einer Spannungsquelle und der Rückkontakt 3 mit dem anderen Pol der Spannungsquelle elektrisch verbunden, wobei eine punktuelle Kontaktierung des Kontaktgitters 5 ausreichend ist. So genügt beispielsweise das Aufsetzen einer Kontaktleiste 12 auf den Enden der Busbars 6. Mit der Spannungsquelle wird dann eine entgegen der Vorwärtsrichtung der Siliziumsolarzelle 1 gerichtete Spannung angelegt. Die Spannung sollte dabei betragsmäßig niedriger sein als die Durchbruchsspannung der Siliziumsolarzelle 1. Beim Anliegen dieser Spannung wird dann eine Punktlichtquelle 13 über die sonnenzugewandte Seite der Siliziumsolarzelle 1 geführt. Durch die punktuelle Beleuchtung von Teilbereichen der sonnenzugewandten Seite der Siliziumsolarzelle 1 wird ein lichtinduzierter Stromfluss erzeugt welcher durch die angelegte Spannungsquelle verstärkt wird, der die zuvor beschriebene Erwärmung des Übergangs zwischen Kontaktgitter 5 und Emitterschicht hervorruft. Vorteilhaft ist hierbei, dass das Kontaktgitter 5 nur punktuell kontaktiert werden muss. Weiterhin können ausgewählte Bereiche der Siliziumsolarzelle 1 gezielt bearbeitet werden. So können beispielsweise mit bildgebenden Verfahren wie der Elektrolumineszenz oder dem CoreScan Bereiche mit erhöhtem Kontaktwiderstand ermittelt und gezielt behandelt werden.

Die Punktlichtquelle 13 ist als Laser ausgeführt, wobei das Verfahren nicht auf diesen beschränkt ist. Der Laser kann dabei eine gepulste oder eine kontinuierliche Laserstrahlung erzeugen. Als kostengünstige Varianten können z.B. Diodenlaser oder CO2-Laser eingesetzt werden.

Für eine übliche Siliziumsolarzelle wird eine Verbesserung des ohmschen Kontaktverhaltens zwischen dem Kontaktgitter und der Emitterschicht beispielsweise mit einer Rückwärtsspannung von 12 V, einer Laserleistung von 0,5 W, einer Laserwellenlänge von 1062 nm und einer Laserspotgröße von 60 µm erreicht, wobei der damit erzeugte Stromfluss im Bereich von 100 mA liegt. Wird die Siliziumsolarzelle bei einem Laservorschub von 10 m/s mit einem Linienabstand von 1 mm abgerastert, liegt die Prozesszeit bei etwa 3 s.

### Bezugszeichenliste

- 1: Siliziumsolarzelle
- 2: Absorberschicht
- 3: Rückkontakt
- 4: Siliziumnitridschicht
- 5: Kontaktgitter
- 6: Busbar
- 7: Kontaktfinger
- 8: Kontaktstift-Matrix
- 9: Kontaktstift
- 10: Kontaktbürste
- 11: Kontaktwalze
- 12: Kontaktleiste
- 13: Punktlichtquelle

## Patentansprüche

1. Verfahren zur Verbesserung des ohmschen Kontaktverhaltens zwischen einem aus Metallpaste aufgebauten Kontaktgitter und einer Emitterschicht einer Siliziümsolarzelle, **dadurch gekennzeichnet,**
**dass** zunächst die Siliziumsolarzelle (1) mit der Emitterschicht, dem Kontaktgitter (5) und einem Rückkontakt (3) bereitgestellt wird und dass das Kontaktgitter (5) von einer mit einem Pol einer Stromquelle verbundenen ersten Kontaktiereinrichtung elektrisch kontaktiert wird und dass der Rückkontakt (3) von einer mit dem anderen Pol der Stromquelle verbundenen zweiten Kontaktiereinrichtung elektrisch verbunden wird und dass mit der Stromquelle mindestens ein Strompuls mit einer Pulslänge von 1 ms bis 100 ms und einer Stromstärke, die dem 10- bis 30-fachen der unter Standard-Testbedingungen gemessenen Kurzschlussstromstärke der Siliziumsolarzelle (1) entspricht, entlang der Vorwärtsrichtung der Siliziumsolarzelle (1) induziert wird.

2. Verfahren nach Anspruch 1, **dadurch gekennzeichnet,**
**dass** die erste Kontaktiereinrichtung eine Kontaktstift-Matrix (8) oder eine Kontaktplatte ist.

3. Verfahren zur Verbesserung des ohmschen Kontaktverhaltens zwischen einem aus Metallpaste aufgebauten Kontaktgitter und einer Emitterschicht einer Siliziumsolarzelle, **dadurch gekennzeichnet,**
**dass** zunächst die Siliziumsolarzelle (1) mit der Emitterschicht, dem Kontaktgitter (5) und einem Rückkontakt (3) bereitgestellt wird und dass ein Teilbereich des Kontaktgitters (5) von einer mit einem Pol einer Stromquelle verbundenen Kontaktbürste (10) oder Kontaktwalze (11) elektrisch kontaktiert wird und dass der Rückkontakt (3) von einer mit dem anderen Pol der Stromquelle verbundenen Kontaktiereinrichtung elektrisch verbunden wird und dass die Kontaktbürste (10) oder die Kontaktwalze (11) über das Kontaktgitter (5) geführt wird und dass dabei mit der Stromquelle ein Stromfluss entlang der Vorwärtsrichtung der Siliziumsolarzelle (1) induziert wird und dass dieser Stromfluss für 1 ms bis 100 ms auf den Teilbereich einwirkt und dass der Stromfluss eine Stromstärke aufweist, die der um das Verhältnis aus der Fläche des Teilbereichs zur Fläche der Siliziumsolarzelle (1) reduzierten 10- bis 30-fachen der unter Standard-Testbedingungen gemessenen Kurzschlussstromstärke der Siliziumsolarzelle (1) entspricht.

4. Verfahren zur Verbesserung des ohmschen Kontaktverhaltens zwischen einem aus Metallpaste aufgebauten Kontaktgitter und einer Emitterschicht einer Siliziumsolarzelle, **dadurch gekennzeichnet,**
**dass** zunächst die Siliziumsolarzelle (1) mit der Emitterschicht, dem Kontaktgitter (5) und einem Rückkontakt (3) bereitgestellt wird und dass das Kontaktgitter (5) mit einem Pol einer Spannungsquelle elektrisch verbunden wird und dass eine mit dem anderen Pol der Spannungsquelle elektrisch verbundene Kontaktiereinrichtung mit dem Rückkontakt (3) verbunden wird und dass mit der Spannungsquelle eine entgegen der Vorwärtsrichtung der Siliziumsolarzelle (1) gerichtete Spannung, die betragsmäßig geringer ist als die Durchbruchsspannung, angelegt wird und dass beim Anliegen dieser Spannung eine Punktlichtquelle (13) über die sonnenzugewandte Seite der Siliziumsolarzelle (1) geführt wird und dass dabei ein Teilbereich der sonnenzugewandten Seite punktuell beleuchtet wird und dass damit ein Stromfluss in dem Teilbereich induziert wird und dass dieser Stromfluss für 1 ms bis 100 ms auf den Teilbereich einwirkt und dass der Stromfluss eine Stromstärke aufweist, die der um das Verhältnis aus der Fläche des Teilbereichs zur Fläche der Siliziumsolarzelle (1) reduzierten 10- bis 30-fachen der unter Standard-Testbedingungen gemessenen Kurzschlussstromstärke der Siliziumsolarzelle (1) entspricht.

5. Verfahren nach Anspruch 4, **dadurch gekennzeichnet,**
**dass** die Punktlichtquelle (13) ein Laser ist.

## Claims

1. Method for improving the ohmic-contact behaviour between a contact grid consisting of metal paste and an emitter layer of a silicon solar cell, **characterized in that** the silicon solar cell (1) is first provided with the emitter layer, the contact grid (5) and a rear contact (3), and that the contact grid (5) is electrically contacted by a first contacting device connected to one pole of a current source and the rear contact (3) is electrically contacted by second contacting device connected to the other pole of the current source, and that with the current source at least one current pulse is induced with a pulse length of 1 ms to 100 ms and a current magnitude corresponding to 10-to-30 times the short-circuit magnitude of the silicon solar cell (1) measured under standard test conditions along the forward direction of the silicon solar cell (1).

2. Method according to claim 1, **characterized in that**
the first contacting device is a contact-pin matrix (8) or a contact plate.

3. Method for improving the ohmic-contact behaviour between a contact grid consisting of metal paste and an emitter layer of a silicon solar cell **characterized in that** the silicon solar cell (1) is first provided with the emitter layer, the contact grid (5) and a rear contact (3), and a subsection of the contact grid (5) is electrically contacted by means of a contact brush (10) or contact roller (11) connected to one pole of a current source and the rear contact (3) is electrically contacted by means of a contacting device connected to the other pole of the current source, and that the contact brush (10) or the contact roller (11) is guided over the contact grid (5) and a current flow is induced along the forward direction of the silicon solar cell (1) by means of the current source and the subsection is exposed to this current flow for 1 ms to 100 ms, the current having a magnitude corresponding to 10-to-30 times the short-circuit magnitude of the silicon solar cell (1) reduced by the ratio of the area of the subsection to the area of the silicon solar cell (1) measured under standard test conditions.

4. Method for improving the ohmic-contact behaviour between a contact grid consisting of metal paste and an emitter layer of a silicon solar cell **characterized in that** the silicon solar cell (1) is first provided with the emitter layer, the contact grid (5) and a rear contact (3), and that the contact grid (5) is electrically connected to one pole of a voltage source and a contacting device that is electrically connected to the other pole of the voltage source is connected to the rear contact (3) and a voltage directed opposite to the forward direction of the silicon solar cell (1) is applied by the voltage source that is lower than the breakdown voltage, and that a point light source (13) is guided over the sun-facing side of the silicon solar cell (1) while this voltage is applied, and that a subsection of the sun-facing side is point illuminated, inducing a current to flow in the partial area, and that this current acts on the subsection for 1 ms to 100 ms, the current being of a magnitude corresponding to 10-to-30 times the short-circuit current magnitude of the silicon solar cell (1) reduced by the ratio of the area of the subsection to the area of the silicon solar cell (1) measured under standard test conditions.

5. Method according to claim 4, **characterized in that**
the point light source (13) is a laser.

## Revendications

1. Procédé visant à améliorer le comportement au contact ohmique entre une grille de contact constituée à partir de pâte métallique et une couche émettrice d'une cellule solaire au silicium, **caractérisé en ce que**
la cellule solaire au silicium (1) est munie dans un premier temps de la couche émettrice, de la grille de contact (5) et d'un contact arrière (3) et **en ce que** la grille de contact (5) est mise en contact électriquement par un premier dispositif de mise en contact relié à un pôle d'une source d'alimentation et **en ce que** le contact arrière (3) est raccordé électriquement par un deuxième dispositif de mise en contact relié à l'autre pôle de la source d'alimentation et **en ce qu'**au moins une impulsion de courant d'une longueur d'impulsion de 1 ms à 100 ms et d'une intensité correspondant à 10 à 30 fois l'intensité du courant de court-circuit du panneau solaire au silicium (1) mesurée dans des conditions d'essai standard, est induite à partir de la source d'alimentation, le long de la direction avant de la cellule solaire au silicium (1).

2. Procédé selon la revendication 1, **caractérisé en ce que**
le premier dispositif de mise en contact est une matrice à broches de contact (8) ou une plaque de contact.

3. Procédé visant à améliorer le comportement au contact ohmique entre une grille de contact constituée à partir de pâte métallique et une couche émettrice d'une cellule solaire au silicium, **caractérisé en ce que**
la cellule solaire au silicium (1) est munie dans un premier temps de la couche émettrice de la grille de contact (5) et d'un contact arrière (3) et **en ce qu'**une surface partielle de la grille de contact (5) est mise en contact électriquement par un balai de contact (10) ou un rouleau de contact (11) relié à un pôle d'une source d'alimentation et **en ce que** le contact arrière (3) est raccordé électriquement par un dispositif de mise en contact relié à l'autre pôle de la source d'alimentation et **en ce que** le balai de contact (10) ou le rouleau de contact (11) est guidé au-dessus de la grille de contact (5) et **en ce qu'**un flux de courant est alors induit le long de la direction avant de la cellule solaire au silicium (1) à partir de la source d'alimentation et **en ce que** ce flux de courant agit pendant 1 ms à 100 ms sur la surface partielle et **en ce que** le flux de courant présente une intensité correspondant à 10 à 30 fois l'intensité du courant de court-circuit de la cellule solaire au silicium (1) mesurée dans des conditions d'essai standard et réduite du rapport entre la surface de la surface partielle et la surface de la cellule solaire au silicium (1).

4. Procédé visant à améliorer le comportement au contact ohmique entre une grille de contact constituée à partir de pâte métallique et une couche émettrice d'un panneau solaire au silicium, **caractérisé en ce que**
la cellule solaire au silicium (1) est munie dans un premier temps de la couche émettrice, de la grille de contact (5) et d'un contact arrière (3) et **en ce que** la grille de contact (5) est reliée électriquement à un pôle d'une source d'alimentation et **en ce qu'**un dispositif de mise en contact relié électriquement à l'autre pôle de la source d'alimentation est raccordé au contact arrière (3) et **en ce qu'**à partir de la source d'alimentation, une tension orientée dans le sens opposé à la direction avant de la cellule solaire au silicium (1) et inférieure en termes de valeur à la tension de rupture est appliquée et **en ce que** lorsque cette tension est appliquée, une source lumineuse ponctuelle (13) est guidée par le côté faisant face au soleil de la cellule solaire au silicium (1) et **en ce que** durant ce processus une sous-section du côté faisant face au soleil est alors éclairée ponctuellement et **en ce qu'**un flux de courant est ainsi induit dans la sous-section et **en ce que** ce flux de courant agit pendant 1 ms à 100 ms sur la surface partielle et **en ce que** le flux de courant présente une intensité correspondant à 10 à 30 fois l'intensité du courant de court-circuit de la cellule solaire au silicium (1) mesurée dans des conditions d'essai standard et réduite du entre la surface de la sous-section et la surface de la cellule solaire au silicium (1).

5. Procédé selon la revendication 4, **caractérisé en ce que**
la source lumineuse ponctuelle (13) est un laser.
